# FASCICULE DE BREVET EUROPEEN

(11) **EP 1 222 624 B1**
(45) Date de publication et mention de la délivrance du brevet: **09.05.2007**
(21) Numéro de dépôt: 00985346.6
(22) Date de dépôt: 28.11.2000
(51) Int. Cl.: G06K 19/077, H01L 23/32, H05K 3/46

(54) **CARTE A PUCE SANS CONTACT OU HYBRIDE CONTACT - SANS CONTACT PERMETTANT DE LIMITER LES RISQUES DE FRAUDE**
KONTAKTLOSE CHIPKARTE ODER KONTAKT/KONTAKTLOSE HYBRID-CHIPKARTE MIT BETRUGSVERHINDERUNG
NON-CONTACT OR NON-CONTACT HYBRID SMART CARD FOR LIMITING RISKS OF FRAUD

(30) Priorité: 29.11.1999 FR 9915020
(43) Date de publication de la demande: 17.07.2002
(73) Titulaire: ASK S.A., 06560 Valbonne (FR)
(72) Inventeur: KAYANAKIS, Georges, F-06000 Antibes (FR)
(86) Numéro de dépôt international: PCT/FR2000/003323
(87) Numéro de publication internationale: WO 2001/041062

(56) Documents cités:
- EP-A- 0 198 376
- WO-A-94/11846
- DE-A- 4 403 513
- DE-A- 19 601 358
- US-A- 5 888 624

## Description

### Domaine technique:

La présente invention concerne les cartes à puce, et plus particulièrement une carte sans contact ou hybride contact - sans contact, dont l'antenne est sur un support en papier.

### Etat de la technique :

La carte sans contact est un système de plus en plus utilisé dans différents secteurs. Ainsi, dans le secteur des transports, elle a été développée comme moyen de paiement. C'est le cas également du porte-monnaie électronique. De nombreuses sociétés ont également développé des moyens d'identification de leur personnel par cartes à puce sans contact.

L'échange d'informations entre une carte sans contact et le dispositif de lecture associé s'effectue par couplage électromagnétique à distance entre une antenne logée dans la carte sans contact et une deuxième antenne située dans le lecteur. Pour élaborer, stocker et traiter les informations, la carte est munie d'une puce ou d'un module électronique qui est relié(e) à l'antenne. L'antenne et la puce se trouvent généralement sur un support diélectrique en matière plastique (polychlorure de vinyle (PVC), polyester (PET), polycarbonate (PC)...). L'antenne est obtenue par gravure chimique du cuivre ou de l'aluminium sur le support ou bobinage d'un fil de métal conducteur.

La carte est souvent monobloc. En effet, le support d'antenne est inséré entre deux couches en matière plastique (PVC, PET, PC, acrylonitrile-butadiène-styrène (ABS)...) constituant les corps de carte supérieur et inférieur et thermosoudées par lamination sous pression à chaud. La puce ou le module est connecté à l'antenne par une colle conductrice ou équivalent qui permet d'établir le contact ohmique.

Toutefois, une carte de ce type possède plusieurs inconvénients majeurs. L'inconvénient le plus important est que la thermosoudure plastique, mise en oeuvre au moment de la lamination, conduit à une carte monobloc dont les propriétés mécaniques sont médiocres en terme de restitution des contraintes absorbées. Lorsque des contraintes excessives de torsions flexions sont appliquées, la totalité de la contrainte imposée est transmise à la puce ou au module électronique et plus particulièrement aux points de colle assurant les connexions. La tenue mécanique des joints de colle est soumise à rude épreuve et cela peut se traduire par une rupture de la connexion module - antenne ou puce - antenne. L'antenne peut également être coupée du fait de ces contraintes mécaniques.

Ainsi, cette spécificité a été exploitée par les fraudeurs, incités à la fraude par la mise à disposition dans le grand public de la technologie « carte à puce ».

Outre la fraude organisée à grande échelle qui nécessite de grands moyens et des spécialistes techniques très pointus qui consiste à reproduire le comportement d'une vraie carte par un autre objet technique, la fraude individuelle est la fraude la plus pernicieuse en ceci qu'elle met en scène des individus qui sont les clients de l'organisme émetteur de la carte.

On peut distinguer la fraude occasionnelle qui consiste à utiliser la carte dans une autre application que celle pour laquelle elle est conçue ou à ne pas respecter les conditions d'utilisation prescrites par l'émetteur.

Il existe également la fraude intentionnelle indirecte qui consiste, pour un utilisateur peu au fait de la technique, à essayer d'obtenir d'autres services avec une carte qui n'est pas programmée pour. C'est le cas de la personne qui essaie d'obtenir de l'argent à un distributeur automatique de billets de banque avec une carte de transport.

Enfin, le dernier type de fraude est la fraude intentionnelle directe. Dans ce cas, l'utilisateur a bien assimilé le fonctionnement de la carte et connaît les faiblesses de celle-ci. Il est alors relativement aisé pour ce type d'individus de détruire la carte aussi proprement que possible, par pliages intensifs répétés, lorsqu'ils sont en possession d'une carte vendue avec un crédit (cartes de téléphone, cartes de transports en commun, cartes de paiement aux gares de péages autoroutiers), et que ce crédit est écoulé ou quasiment écoulé sans que l'on puisse prouver, a posteriori, l'intention de frauder. L'antenne peut alors être coupée, la puce ou le module être déconnecté, sans que la carte soit marquée. En effet, de part sa nature, le plastique permet des déformations importantes sans que des traces visibles apparaissent.

Dans ces trois types de fraude, les fraudeurs vont faire valoir que la carte a un défaut de fonctionnement et vont essayer de se la faire échanger ou rembourser auprès des organismes émetteurs. Ces derniers sont alors confrontés à un grave dilemme puisqu'ils veulent à la fois bien traiter leurs clients sincères et ne pas tomber dans le piège fort coûteux d'un remboursement aveugle donnant une prime à la fraude.

Un autre inconvénient de ces cartes est qu'elles sont constituées d'un empilage composite de matériaux plastiques collés ou thermosoudés avec des coefficients de dilatation thermique différents. Par conséquent, on observe systématiquement des déformations irréversibles des cartes (vrillage, gauchissement) inacceptables pour l'utilisateur, ainsi qu'un manque de tenue mécanique lors de l'application d'essais normalisés ou équivalents.

De plus, les propriétés thermomécaniques du PVC sont médiocres. Lors de la lamination des corps de carte, le fluage de matière est très important et le facteur de forme de l'antenne n'est pas conservé. Cela entraîne un dysfonctionnement de l'antenne car les paramètres électriques (inductance et résistance) varient. Plus grave, il n'est pas rare d'observer des coupures d'antennes aux endroits où les contraintes de cisaillement sont fortes. C'est le cas notamment dans les angles ou au niveau des pontages électriques.

L'épaisseur totale des cartes ISO laminées varie entre 780 et 840 µm. Compte tenu des flux de matière décrits précédemment, il est également très difficile de garantir aux clients une distribution étroite et contrôlée de la population de cartes.

Un autre défaut majeur de ces cartes est qu'après lamination, l'empreinte des pistes de cuivre est visible sur les corps de carte imprimés. Sans conséquence pour le bon fonctionnement de la carte, ce défaut est très souvent mis en avant par les utilisateurs très sensibles aux critères esthétiques.

Enfin, les coûts de fabrication de telles cartes sont trop élevés pour permettre un réel accroissement de leur utilisation.

### Exposé de l'invention:

Le but de l'invention est de pallier ces inconvénients en fournissant un carte à puce sans contact ou hybride contact - sans contact permettant de limiter les risques de fraude en conservant la trace d'une tentative d'endommagement, tout en résistant aux déformations, possédant une bonne tenue mécanique, conservant donc son facteur de forme ce qui permet de garantir l'intégrité des paramètres électriques.

L'invention concerne donc une carte à puce sans contact ou hybride contact - sans contact, comprenant une antenne sur un support, cette antenne étant constituée d'au moins une spire d'encre conductrice sérigraphiée sur le support, deux corps de carte de chaque côté du support, chacun des corps de carte étant constitué d'au moins une couche de matière plastique, et d'une puce ou d'un module connecté à l'antenne. Le support est en papier et possède des découpes à chaque coin au niveau desquelles sont soudés entre eux les deux corps de carte, lui donnant ainsi la capacité, lorsque la carte est soumise à un pliage, de se délaminer à l'endroit où s'exercent les forces de contraintes générées par le pliage, ce qui permet de mettre en évidence, a posteriori, un acte de dégradation volontaire, la carte conservant la trace du pliage.

### Descrition brève des figures :

Les buts, objets et caractéristiques de l'invention ressortiront mieux à la lecture de la description qui suit faite en référence aux dessins joints dans lesquels :
La figure 1 représente le dessin inversé de l'antenne sur le support en papier d'une carte à puce hybride contact - sans contact.
La figure 2 représente la face du support en contact avec le corps de carte dans lequel est fraisée la cavité pour le module d'une carte à puce hybride contact - sans contact.
La figure 3 représente une carte à puce hybride contact - sans contact dans sa configuration définitive.
La figure 4 est une coupe transversale de la carte à puce représentée à la figure 3, selon l'axe A-A.
La figure 5 représente une carte à puce sans contact dans sa configuration définitive.
La figure 6 est une coupe transversale de la carte à puce représentée à la figure 5, selon l'axe B-B.

### Description détaillée de l'invention:

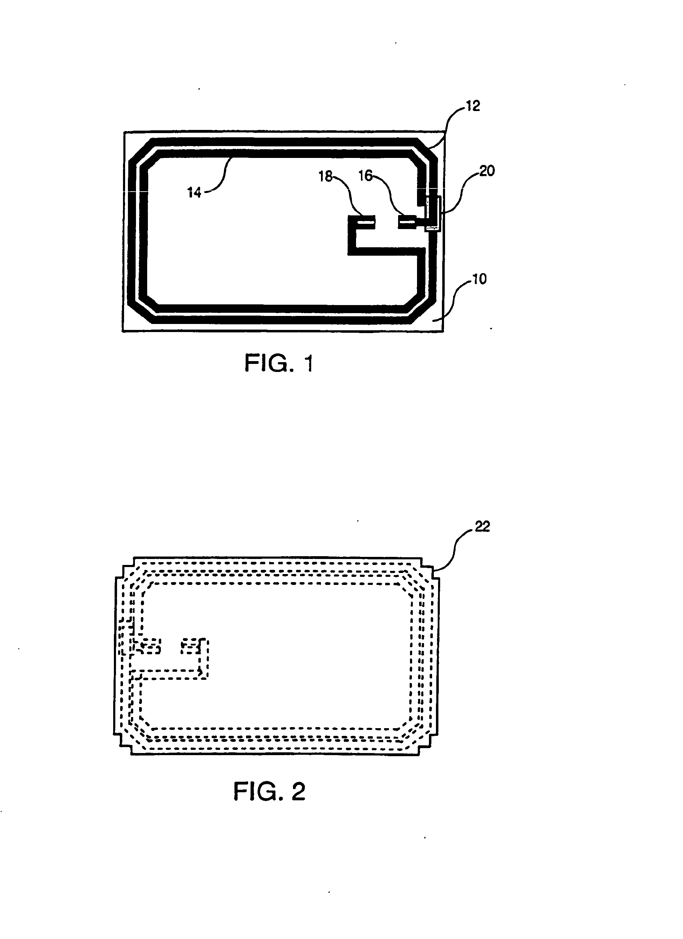

D'après la figure 1, la carte à puce selon l'invention est constituée d'un support en papier 10 sur lequel est sérigraphiée une antenne. L'antenne est constituée de deux spires 12 et 14, d'encre conductrice polymère sérigraphiée, chargée en éléments conducteurs tels que l'argent, le cuivre ou le carbone. Chaque spire a une de ses extrémités reliée à un des plots de connexion de l'antenne au module également sérigraphiés, la spire 12 étant reliée au plot 16 et la spire 14 au plot 18. Les spires sont reliées entre elles par un pont électrique appelé plus communément cross-over (non représenté sur la figure). Un bande isolante 20 d'encre diélectrique est sérigraphiée entre le cross-over et la spire 12. Le dessin de l'antenne est inversé par rapport au dessin normal d'une antenne pour carte à puce au format ISO. Cette configuration particulière permet d'obtenir une carte à puce hybride contact
- sans contact avec une cavité pour loger le module, fraisée dans le corps de carte qui est opposé à la face du support portant la sérigraphie, c'est à dire dans le corps de carte qui est en contact avec la face du support ne portant pas la sérigraphie.

Ainsi, lorsque le support est renversé (plots de connexion à gauche), comme représenté à la figure 2, on constate que les plots de connexion du module se retrouvent à l'emplacement normalisé pour les cartes au format ISO.

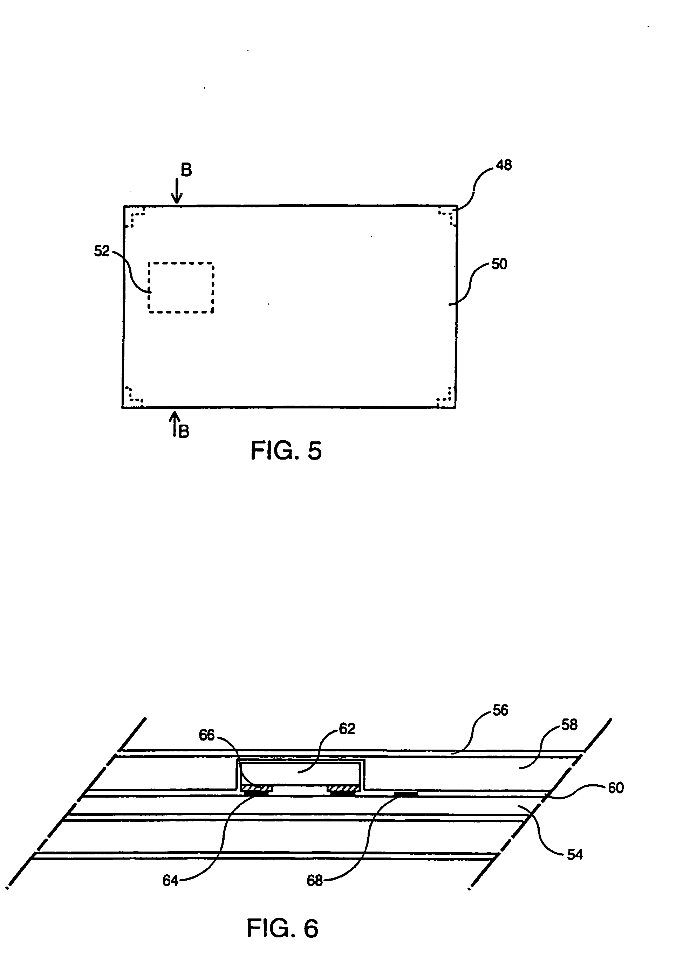

Dans le cas d'une carte à puce purement sans contact telle que représentée sur les figures 5 et 6, le dessin de l'antenne n'est pas inversé. En effet, la puce étant positionnée entre le support d'antenne et un des corps de carte, la carte ne comporte pas de cavité fraisée. L'antenne n'a donc pas besoin d'être protégée. La structure d'une telle carte est donc plus classique.

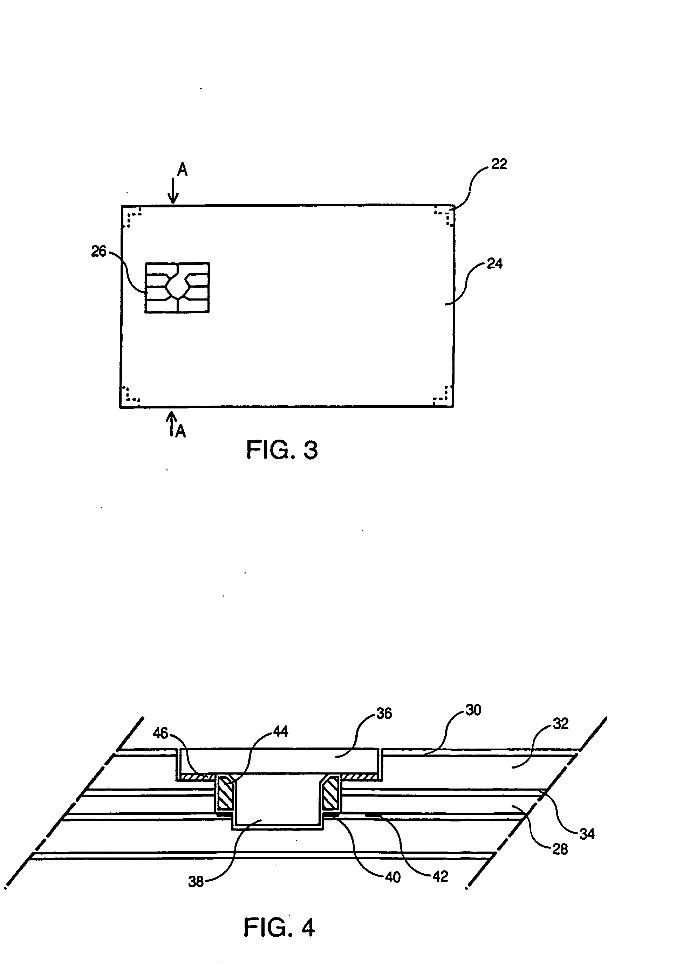

La carte à puce hybride contact - sans contact est représentée à la figure 3 dans sa configuration définitive. Comme représenté sur les figures 2 et 3, le support possède une découpe 22 à chaque coin. Ainsi, lors de la lamination, les corps de carte 24 en matière plastique sont thermosoudés l'un avec l'autre au niveau de ces découpes 22. La pâte à papier possédant une faible cohésion interne, lorsqu'elle est soumise à des contraintes de cisaillement, l'âme du papier a tendance à se délaminer. Cette propriété physique a été mise à profit pour créer une carte avec un marqueur de contraintes intégré. En effet, en bloquant les coins de la carte par soudure entre les deux corps de carte, toutes les contraintes mécaniques sont transmises à l'intérieur de la carte, à l'endroit où les forces de contraintes s'exercent lorsque la carte est soumise à un pliage. Si ces contraintes sont trop fortes, le papier se délamine et la carte s'ouvre jusqu'à séparation complète en deux parties (la partie qui contient l'antenne connectée au module continue de fonctionner). La soudure des corps de carte dans les coins permet à la carte de rester utilisable. En jouant sur la nature du papier et sur sa cohésion interne, on peut obtenir un marqueur de contraintes dont la sensibilité est modulable.

La matière plastique des corps de carte est le polychlorure de vinyle (PVC), du polyester (PET, PETG), du polycarbonate (PC) ou de l'acrylonitrile-butadiène-styrène (ABS). Le module 26 est installé dans la cavité et connecté à l'antenne. Une coupe transversale de la carte d'identification selon l'axe A-A, telle que représentée à la figure 4, permet de mieux comprendre sa configuration.

Le support en papier est pris en sandwich entre les deux corps de carte. Chaque corps de carte est constitué d'au moins une feuille de matière plastique. Préférentiellement, chaque corps de carte est constitué de deux feuilles, la feuille constituant la couche externe et la feuille constituant la couche interne. Selon un mode de réalisation particulier, ces couches peuvent être de rigidité différente. Dans ce cas, la couche externe est en matière plastique rigide et la couche interne est en matière plastique molle ayant un bas point Vicat (température à laquelle la matière plastique passe de l'état solide à l'état caoutchouteux). Les couches peuvent également être d'épaisseur différentes. La couche externe est alors plus épaisse que la couche interne. En effet, la couche externe a une épaisseur d'environ 310 microns (*µ*m) et la couche interne une épaisseur d'environ 80 µm. La matière plastique utilisée est préférentiellement le PVC. L'antenne sérigraphiée est emprisonnée dans la couche interne du corps de carte. Grâce à la faible rigidité du PVC utilisé, lors de la lamination des corps de carte, celui-ci se fluidifie et emprisonne la partie sérigraphiée dans la masse. L'antenne est ainsi beaucoup plus résistante aux contraintes mécaniques lors de l'utilisation de la carte d'identification.

Selon la figure 4, le support en papier 28 de l'antenne est inséré entre deux corps de carte constitués, selon un mode de réalisation préféré, de trois feuilles. Chaque corps de carte comprend une couverture 30 qui peut être une feuille de PVC transparent ou une couche de vernis, une feuille constituant la couche externe de PVC rigide 32 et une feuille constituant la couche interne de PVC mou 34. La couverture 30 a une épaisseur d'environ 40 µm, la couche externe a une épaisseur d'environ 275 µm et la couche interne une épaisseur d'environ 40 µm. L'épaisseur de ces deux dernières couches pouvant varier en fonction de la souplesse finale de la carte. Le module, constitué par le circuit double face 36 et la puce 38 protégée par une résine de surmoulage, est inséré dans la cavité prévue à cet effet. Cette cavité est obtenue par fraisage du corps de carte qui est opposé à la face du support papier portant l'antenne. Le module ainsi installé est connecté aux plots de connexion 40 de l'antenne. Une spire 42 de l'antenne, reliée a un des plots de connexion, est emprisonnée dans la couche interne 34 du corps de carte en PVC mou. Le module est collé sur la carte. Deux colles différentes sont utilisées à cette fin. La première est une colle conductrice 44 qui permet de connecter le module aux plots de l'antenne. Cette colle est préférentiellement une colle contenant de l'argent. La deuxième colle 46 utilisée est une colle qui scelle le module à la carte. On utilise une colle cyanoacrylate. Il est également possible d'utiliser une colle « hot-melt » en film qui est placée sous le module avant son insertion dans la carte.

La figure 5 représente la carte à puce sans contact selon l'invention. Le support d'antenne en papier possède des découpes 48 dans les coins. Ce support est pris en sandwich entre les corps de carte 50. Contrairement à la carte hybride contact - sans contact, aucun des deux corps de carte ne possède de cavité. Cette carte ne possède pas un module mais une puce 52 noyée dans la carte qui n'est donc pas visible à la surface de la carte. Une coupe transversale de cette carte, selon l'axe B-B, est représentée à la figure 6.

A la figure 6, la carte sans contact a la même structure que la carte hybride contact - sans contact. En effet, le support en papier 54 est pris en sandwich entre deux corps de carte. Chaque corps de carte est constitué, selon un mode de réalisation préféré, de trois feuilles. Chaque corps de carte comprend une couverture 56 qui peut être une feuille de PVC transparent ou une couche de vernis, une feuille constituant la couche externe de PVC rigide 58 et une feuille constituant la couche interne de PVC mou 60. La puce 62 est fixée sur le support 54 et est directement connectée aux plots de connexion 64 de l'antenne grâce à une couche de colle conductrice permettant de réaliser les contacts ohmiques. Une spire 68 de l'antenne, reliée a un des plots de connexion, est emprisonnée dans la couche interne 60 du corps de carte en PVC mou. La puce est donc emprisonnée entre le support en papier et un des deux corps de carte. La carte purement sans contact a donc la même structure que la carte hybride contact - sans contact et possède donc les mêmes propriétés.

Selon un autre mode de réalisation particulier, au moins un des deux corps de cartes est constitué de feuilles transparentes afin de rendre visible le support papier et plus particulièrement un graphisme imprimé sur le support. En effet, les techniques d'impressions graphiques sur les supports papier sont connues et parfaitement maîtrisées. La qualité obtenue est remarquable en ce qui concerne la résolution et le rendu des couleurs, comparée à celle obtenue sur un support plastique type PVC. Cette propriété unique du papier peut être mise à profit pour fabriquer des cartes dont au moins une des face du support peut être dédiée à une impression graphique haute qualité. Il devient alors facile d'apposer sur la carte, des publicités, la marque de la société qui distribue les cartes ou encore des photographies d'identité lorsqu'il s'agit de cartes à puce personnelles.

Le comportement de la carte à puce avec un support papier selon l'invention, est totalement différent de celui d'une carte monobloc en PVC. En effet, le papier est un matériau fibreux qui absorbe une partie de l'énergie emmagasinée lorsque la carte est soumise à des contraintes mécaniques. Cet effet amortisseur atténue l'effet ressort naturel des corps de carte. Ainsi, lors de tests de flexion et de torsion de la carte à puce, l'énergie se répercute au centre du support papier et non plus au niveau des connexions du module ou de la puce à l'antenne, comme sur les cartes monobloc en PVC. La connexion du module ou de la puce et l'intégrité de l'antenne sont donc préservée.

Ainsi, la carte selon l'invention, possède deux qualités majeures pour les sociétés qui l'utilisent : la préservation des composantes électriques confère à cette carte une solidité plus importante et la propriété de délamination du papier permet, en cas de panne de la carte, de vérifier que la carte n'a pas subi de pliages intensifs dans le but de frauder. En effet, lorsqu'un utilisateur de la carte tord volontairement ou involontairement celle-ci de façon excessive, le support en papier se délamine. Contrairement aux cartes en PVC, la marque de la torsion ou du pliage apparaît sur la carte. Si la torsion ou le pliage est extrême, une fissure dans le corps de carte apparaît. Malgré cette torsion ou ce pliage, la carte fonctionne toujours. Cette situation dissuade donc le fraudeur de poursuivre ses tentatives de mettre la carte hors d'usage pour ensuite aller réclamer son remboursement ou son échange auprès de l'organisme émetteur, vu les traces laissées sur la carte.

De plus, le caractère visco-élastique de l'encre polymère utilisée pour la sérigraphie permet aux spires de mieux résister aux contraintes mécaniques lors de la lamination. On évite ainsi les coupures d'antenne aux endroits où les contraintes de cisaillement sont importantes.

Enfin, l'empreinte des spires sérigraphiées est pratiquement invisible sur les corps de carte. Ce paramètre qui n'intervient pas dans le fonctionnement de la carte est très important pour les distributeurs et les utilisateurs, qui sont très sensibles aux critères esthétiques.

## Revendications

1. Carte à puce, sans contact ou hybride contact - sans contact, comprenant une antenne sur un support (10), ladite antenne étant constituée d'au moins une spire (12, 14) d'encre conductrice sérigraphiée sur ledit support, deux corps (24) de carte de chaque côté dudit support, chacun desdits corps de carte étant constitué d'au moins une couche de matière plastique, et d'une puce ou d'un module (26) connecté à l'antenne,
ladite carte étant **caractérisée en ce que** ledit support (10) est en papier et possède des découpes (22) à chaque coin au niveau desquelles sont soudés entre eux lesdits corps (24) de carte donnant ainsi la capacité audit support, lorsque ladite carte est soumise à un pliage, de se délaminer à l'endroit où s'exercent les forces de contraintes générées par ledit pliage, ce qui permet de mettre en évidence, a posteriori, un acte de dégradation volontaire, ladite carte conservant les traces du pliage.

2. Carte à puce selon la revendication 1, dans laquelle ledit module (26) est inséré dans une cavité fraisée dans le corps (24) de carte opposé à la face dudit support portant les spires (12, 14) de l'antenne.

3. Carte à puce selon la revendication 1, dans laquelle la puce est positionnée entre ledit support (10) et un desdits corps (24) de carte.

4. Carte à puce selon l'une des revendications précédentes dans laquelle chacun desdits corps (24) de carte est constitué d'au moins deux couches de matière plastique.

5. Carte à puce selon la revendication 4, dans laquelle les deux feuilles constituant lesdites couches des corps de carte sont de rigidité et d'épaisseur différentes.

6. Carte à puce d'identification selon la revendication 5, dans laquelle la feuille constituant la couche externe des corps (24) de carte est en matière plastique rigide et la feuille constituant la couche interne des corps (24) de carte est en matière plastique molle, ayant un bas point Vicat.

7. Carte à puce d'identification selon la revendication 6, dans laquelle la feuille constituant la couche externe est plus épaisse que la feuille constituant la couche interne.

8. Carte à puce d'identification selon la revendication 6, dans laquelle chacun des corps de carte est constitué d'une feuille supplémentaire en matière plastique, ou d'une couche de vernis, jouant le rôle de couverture.

9. Carte à puce selon l'une des revendications précédentes, dans laquelle la matière plastique des corps (24) de carte est le polychlorure de vinyle (PVC), du polyester (PET, PETG), du polycarbonate (PC) ou de l'acrylonitrile-butadiène-styrène (ABS).

10. Carte à puce selon l'une des revendications précédentes, dans laquelle l'encre desdites spires sérigraphiées est une encre conductrice polymère chargée en éléments conducteurs.

11. Carte à puce selon l'une des revendications précédentes, dans laquelle au moins un des deux corps (24) de carte est constituée de feuilles transparentes afin de rendre visible le support papier et plus particulièrement un graphisme imprimé sur ledit support.

## Claims

1. A contactless or hybrid-contact contactless smart card including an antenna on a support (10), said antenna being comprised of at least one turn (12, 14) of electrically conductive ink screen printed on said support, two card bodies (24) on each side of said support, each of said card bodies being made up of at least one layer of plastic material, and a chip or module (26) connected to the antenna,
said card being **characterized in that** said support (10) is made of paper and features cutouts (22) in each corner at which said card bodies (24) are welded together thereby enabling said support to delaminate when bent at the location where, the forces are generated by said bending, which highlights any act of deliberate damage a posteriori as the card retains the traces of the bending.

2. The smart card according to claim 1, in which said module (26) is inserted into a cavity milled in the card body (24) opposite the side of said support bearing the turns (12, 14) of the antenna.

3. The smart card according to claim 1, in which the chip is positioned between said support (10) and one of said card bodies (24).

4. A smart card according to one of the previous claims in which each of said card bodies (24) is comprised of at least two layers of plastic.

5. The smart card according to claim 4, in which the two sheets forming said card body layers have different stiffness and thickness.

6. The identification smart card according to claim 5, in which the sheet forming the external layer of the card bodies (24) is made of a stiff plastic material and the sheet forming the internal layer of the card bodies is made of soft plastic having a low Vicat temperature softening temperature.

7. The identification smart card according to claim 6, in which the sheet forming the external layer is thicker than the sheet forming the internal layer.

8. The identification smart card according to claim 6, in which each of the card bodies are comprised of an additional sheet of plastic material, or layer or varnish, acting as a cover.

9. A smart card according to one of the previous claims, in which the plastic material forming the card bodies (24) is polyvinyl chloride (PVC), polyester (PET, PETG), polycarbonate (PC) or acrylonitrile-butadiene-styrene (ABS).

10. A smart card according to one of the previous claims, in which the ink of said screen printed turns is an electrically conductive polymer ink loaded with conductive elements.

11. A smart card according to one of the previous claims, in which at least one of the two card bodies (24) is made up of transparent sheets in order to have the paper support visible, and specifically a graphic image printed on said support.

## Patentansprüche

1. Kontaktlose Chipkarte oder kontakt/kontaktlose Hybrid-Chipkarte, mit einer Antenne auf einem Träger (10), wobei die Antenne aus mindestens einer Windung (12, 14) einer leitenden Druckfarbe besteht, die durch Siebdruck auf den Träger aufgebracht ist, mit zwei Kartenkörpern (24) auf jeder Seite des Trägers, wobei jeder Kartenkörper aus mindestens einer Schicht aus Plastikmaterial besteht, und mit einem Chip oder einem Modul (26), das mit der Antenne verbunden ist,
wobei die Karte **dadurch gekennzeichnet ist, dass** der Träger (10) aus Papier ist und an jeder Ecke Ausschnitte (22) aufweist, auf deren Ebene die Kartenkörper (24) aneinander geschweißt sind, wodurch dem Träger die Fähigkeit verliehen wird, wenn die Karte umgeknickt wird, sich an der Stelle aufzublättern, wo die Spannungskräfte ausgeübt werden, die durch das Umknicken erzeugt werden, was im Nachhinein den Beweis eines absichtlichen Beschädigungsakts ermöglicht, da die Karte die Spuren des Umknickens behält.

2. Chipkarte nach Anspruch 1, bei der das Modul (26) in einen Hohlraum eingefügt ist, der in den Kartenkörper (24) entgegengesetzt zu der Seite des Trägers eingefräst ist, die die Windungen (12, 14) der Antenne trägt.

3. Chipkarte nach Anspruch 1, bei der der Chip zwischen dem Träger (10) und einem der Kartenkörper (24) positioniert ist.

4. Chipkarte nach einem der vorhergehenden Ansprüche, bei der jeder der Kartenkörper (24) aus mindestens zwei Schichten aus Plastikmaterial besteht.

5. Chipkarte nach Anspruch 4, bei der die zwei die Schichten der Kartenkörper bildenden Folien eine unterschiedliche Steifheit und Dicke aufweisen.

6. Identifikations-Chipkarte nach Anspruch 5, bei der die die äußere Schicht der Kartenkörper (24) bildende Folie aus steifem Plastikmaterial und die die innere Schicht der Kartenkörper (24) bildende Folie aus weichem Plastikmaterial mit einem niedrigen Vicat-Punkt ist.

7. Identifikations-Chipkarte nach Anspruch 6, bei der die die äußere Schicht bildende Folie dicker ist als die die innere Schicht bildende Folie.

8. Identifikations-Chipkarte nach Anspruch 6, bei der jeder der Kartenkörper aus einer zusätzlichen Folie aus Plastikmaterial oder aus einer Lackschicht besteht, die als Abdeckung dient.

9. Chipkarte nach einem der vorhergehenden Ansprüche, bei der das Plastikmaterial der Kartenkörper (24) Polyvinylchlorid (PVC), Polyester (PET, PETG), Polykarbonat (PC) oder Acrylnitril-Butadien-Styrol (ABS) ist.

10. Chipkarte nach einem der vorhergehenden Ansprüche, bei der die Druckfarbe der durch Siebdruck hergestellten Windungen eine mit leitenden Elementen angereicherte leitende Polymer-Druckfarbe ist.

11. Chipkarte nach einem der vorhergehenden Ansprüche, bei der mindestens einer der zwei Kartenkörper (24) aus transparenten Folien besteht, um den Papierträger, und insbesondere ein auf den Träger gedrucktes grafisches Element, sichtbar zu machen.
